# EUROPEAN PATENT APPLICATION

(11) **EP 1 080 842 A1**
(43) Date of publication of application: **07.03.2001**
(21) Application number: 99949342.2
(22) Date of filing: 21.10.1999
(51) Int. Cl.: B24B 37/04, H01L 21/304

(54) **METHOD AND APPARATUS FOR GRINDING WAFER**

(30) Priority: 30.10.1998 JP 31010798; 30.10.1998 JP 31114698
(71) Applicant: Shin-Etsu Handotai Co., Ltd, Tokyo 100-0005 (JP)
(72) Inventor: Tanaka, Kouichi, Shin-Etsu Handotai Co., Ltd., Nishishirakawa-gun, Fukushima (JP)
(74) Representative: Butcher, Ian James
(86) International application number: JP9905811
(87) International publication number: WO0025980

(57) **Abstract**

The present invention provides an apparatus and a method for polishing a wafer which solve faults of a single wafer polishing apparatus that a production cost thereof is high and a batch type polishing apparatus that flatness of a polished wafer obtained thereby is poor.

In the wafer polishing apparatus in which wafers (W) held on a wafer holding plate (12) are pressed onto a polishing cloth (14) stuck on a table (20) with a predetermined polishing load using a loading member (70) and thereby one surface of each of the wafers is polished, the wafer holding plate comprises: a plurality of wafer holding sections (12a) on which the wafers are held respectively; and a connection plate section (12b) that connects a plurality of the wafer holding sections in one united body, the wafer holding sections being formed as high stiffness regions while the connection plate section being formed as a low stiffness region, wherein the plural wafer holding sections are provided with uniform load distribution means (74) for uniformly distributing the polishing load on the plural wafer holding sections respectively.

## Description

### Technical Field

The present invention relates to an apparatus and a method for polishing a wafer in which one surface of a thin plate, for example a semiconductor wafer such as a silicon wafer, a quartz thin plate such as a quartz mask blank or the like (the thin plate is generally referred to as a wafer herein) is efficiently polished.

### Background Art

In keeping with increase of degree of integration in a semiconductor device, high flatness has been demanded in a semiconductor wafer, which is a semiconductor material, for example a silicon wafer. Furthermore, in order to reduce production costs of a semiconductor device, low cost polishing of a surface of the semiconductor wafer is requested.

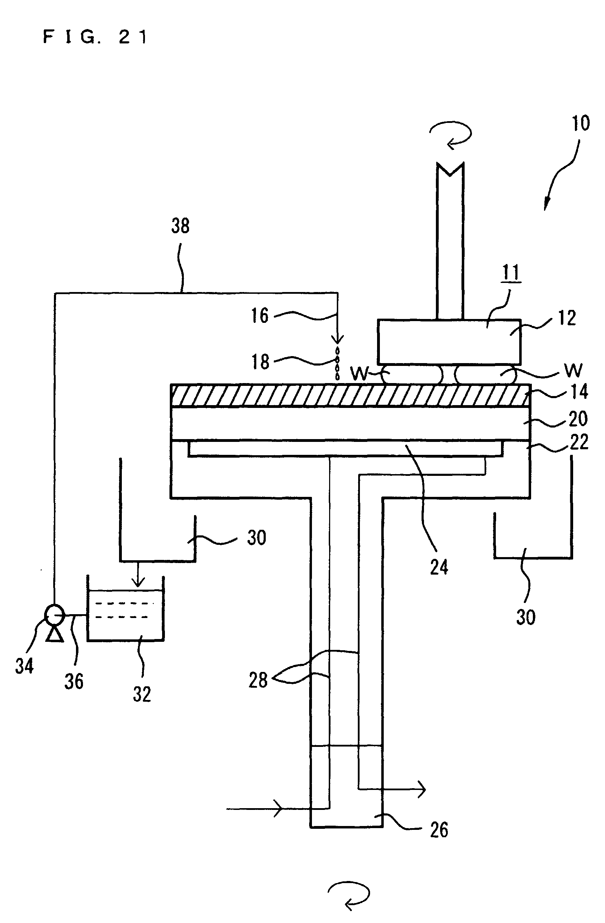

FIG. 21 is an illustrative schematic sectional view of a conventional wafer polishing apparatus 10. In the figure, a semi-conductor wafer (W) is adhered on a surface of a plate constituting a polishing head 11 or a plate (a wafer holding plate) 12 arranged beneath the polishing head 11 using wax or the like, pressed onto a polishing cloth 14 which is stuck on a surface of a table 20 rotating at a predetermined speed, with a predetermined polishing load, and while a polishing agent 18 is supplied from a nozzle 16, the surface of the semiconductor wafer (W) is mirror-polished by a frictional motion occurring between the semiconductor wafer (W) and the polishing cloth 14.

The table 20 and a table support 22 are firmly fixed with bolts or the like and cooling water 28 is supplied into a clearance 24 formed therebetween via a rotary joint 26 so as to remove frictional heat generated by the frictional motion between the polishing cloth 14 and the wafer (W). In FIG. 21, reference character 30 designates a recovery trough for the polishing agent 18, 32 a storage tank for the polishing agent 18, 34 a pump, 36 a connecting pipe that connects the storage tank 32 and the pump 34 and 38 a circulation pipe that connects the pump 34 and the nozzle 16.

In mirror-polishing, flatness is the most important quality that is given to a wafer. With the recent progress of the integration in a semiconductor device, a higher flatness level has increasingly been required.

In order to acquire a wafer with high flatness, since the wafer is processed in such a manner as sandwiched between a plate on its upper surface and a polishing cloth on its under surface, it is necessary that a surface of the plate is flat; that the polishing cloth has a uniform thickness and a uniform elasticity with a contact pressure between the wafer and the polishing cloth, that is, a polishing pressure being uniformly distributed when the wafer is pressed onto the polishing cloth with the polishing load; and that a surface of the table on which the polishing cloth is stuck is flat.

Such wafer polishing apparatuses are broadly classified into two types of a single wafer type and a batch type according to a difference between structures of a polishing head.

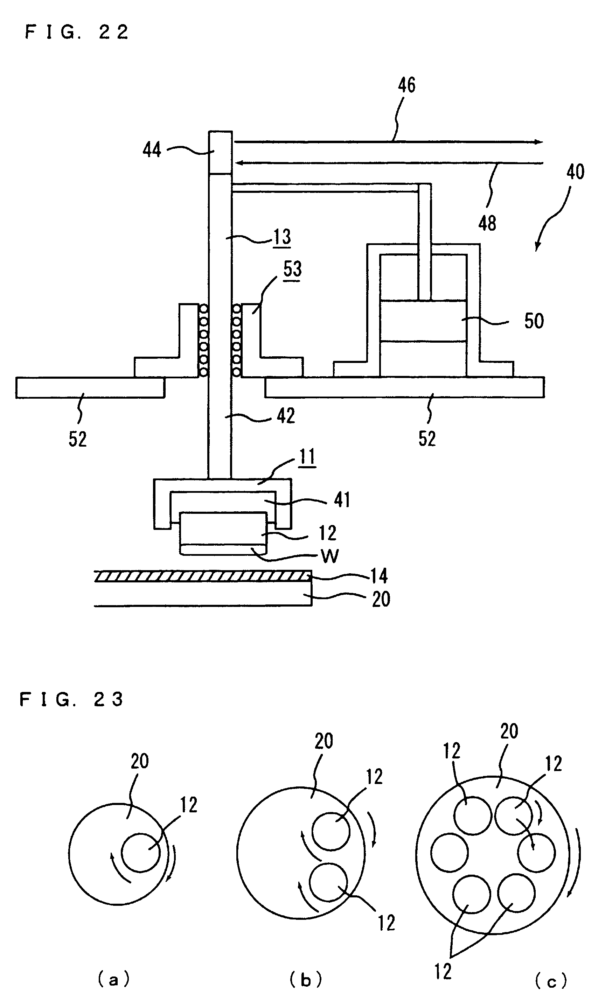

A single wafer polishing apparatus 40, as shown in FIG. 22, comprises one wafer holding plate 12 and one pressure structure 13 both corresponding to one wafer (W). In FIG. 22, above a table 20 and a polishing cloth 14, a polishing head 11 is provided movably upward and downward in a manner opposing thereto. The polishing head 11 comprises a wafer holding plate 12 with an air chamber 41 in between. The wafer (W) is held detachably on an under surface of the wafer holding plate 12.

The polishing head 11 is attached to the lower end of a shaft 42. An air line 46 for vacuum chucking the wafer and an air line 48 for pressurizing the air chamber are set in the shaft 42 through a rotary joint 44 attached to the top end thereof. Reference character 50 designates an air cylinder which drives the polishing head 11 upward and downward by the use of the shaft 42, and is set on a frame 52. Reference character 53 designates a bearing member that slidably supports the shaft 42.

The number of the polished wafers simultaneously polished in one polishing apparatus increases or decreases in compliance with the number of the shafts 42 equipped as shown in FIG. 23. FIG. 23(a) to 23(c) show cases of one shaft, two shafts and six shafts respectively.

Strong points of the single wafer polishing apparatus reside in easily achieving high flatness of the wafers (W) and being comparatively compact because the wafers (W) are individually controlled.

A weak point of the single wafer polishing apparatus resides in a higher per wafer cost of one polishing apparatus because even in the polishing apparatus with one polishing head 11, one set of components such as a table, a frame and others is required.

In order to solve the above weak point, if the polishing head is provided with multiple shafts, per wafer costs of respective components such as a table and a frame are reduced. However, in this case, a per wafer cost associated with a polishing head is unchanged and a mechanism revolving polishing heads is sometimes additionally required. Even if the per wafer cost of the polishing apparatus with the multiple shafts reduces, the cost thereof including the above additional cost could be no match for that of the batch type wafer polishing apparatus described later.

The single wafer polishing apparatus and the batch type wafer polishing apparatus described later both adopt a common principle of material removal that colloidal silica is supplied as a processing liquid while a wafer is rubbed with a polishing cloth, and common processing conditions by the request of wafer quality. Hence, a processing time is common to the two types of the wafer polishing apparatuses, so there is no effect of higher productivity due to processing time reduction.

When polished wafers are mass-produced using single wafer polishing apparatuses, as the number of processed wafers per apparatus is less than in a case of a batch type polishing apparatus, a lot of the apparatuses are required. Hence, a large floor space for installment is necessary in a case of the single wafer polishing apparatus and thereby a construction cost to ensure the installment floor space is higher. That is, as shown above, the single wafer polishing apparatus is inferior to the batch type polishing apparatus in terms of production costs.

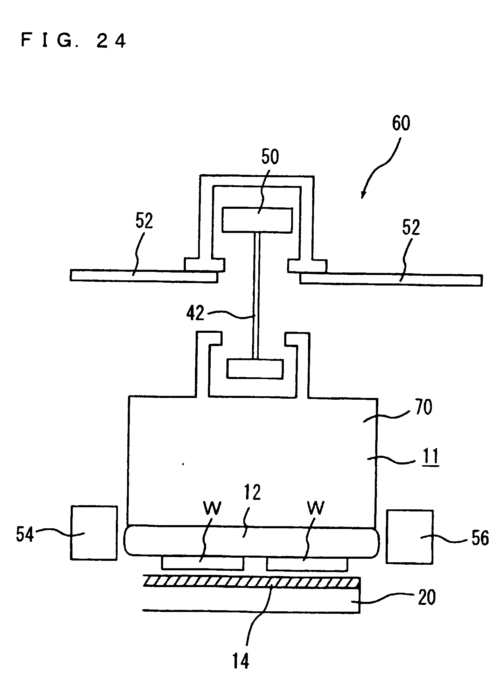

The batch type polishing apparatus 60, as shown in FIG. 24, has a configuration in which many wafers (W) are arranged on one wafer holding plate 12 and a load, for wafer polishing on one wafer holding plate is imparted by one pressure structure. In FIG. 24, above a table 20 and a polishing cloth 14, a polishing head 11 is provided in a manner opposing thereto and movably upward and downward by an air cylinder 50 installed on a frame 52.

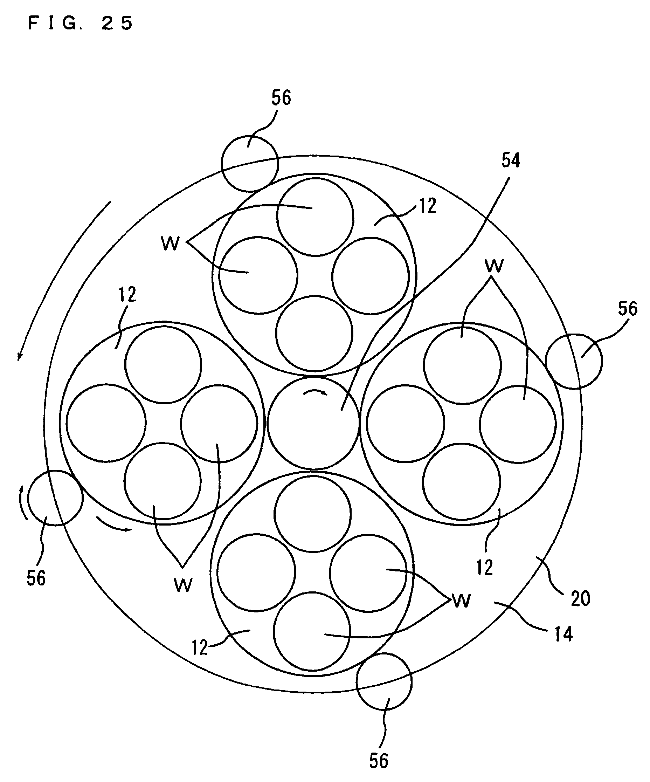

The polishing head 11 is provided with a dead weight 70 as means for imparting a load on wafers through a wafer holding plate 12. A center roller 54 and guide rollers 56 are arranged in contact with the outer circumference of the wafer holding plate 12 and a plurality of the wafer holding plates 12 are driven by the action of the rollers as shown in FIG. 25.

In the apparatus 60, wafers (W) are polished in the following manner. The wafers (W) are adhered on a surface of the wafer holding plate 12 using wax and then placed in the polishing apparatus so as to be in contact with the polishing cloth 14. The polishing head 11 is moved downward, and the dead weight 70 is put on the wafer holding plate 12, thereby a polishing pressure being generated between the wafers (W) and the polishing cloth 14.

When the table 20 is rotated while a polishing agent is supplied, there occurs a rotating motion of the wafer holding plate 12, that is, a relative motion between the wafer (W) and the polishing cloth 14 due to a frictional force between the wafer (W) and the polishing cloth 14, and thereby the wafer (W) is polished.

A strong point of the batch type polishing apparatus 60 is the reverse of the weak point of the aforementioned single wafer polishing apparatus 40 and, as a conclusion, the batch type apparatus is superior to the single wafer type apparatus in terms of production costs.

The batch type wafer polishing apparatus 60 is subject to the influence of external disturbances (deviation from an ideal state) as described below and therefore has a weak point that it is difficult to obtain flatness of a wafer (W) as compared with the single wafer polishing apparatus 40.

### External Disturbance ①:

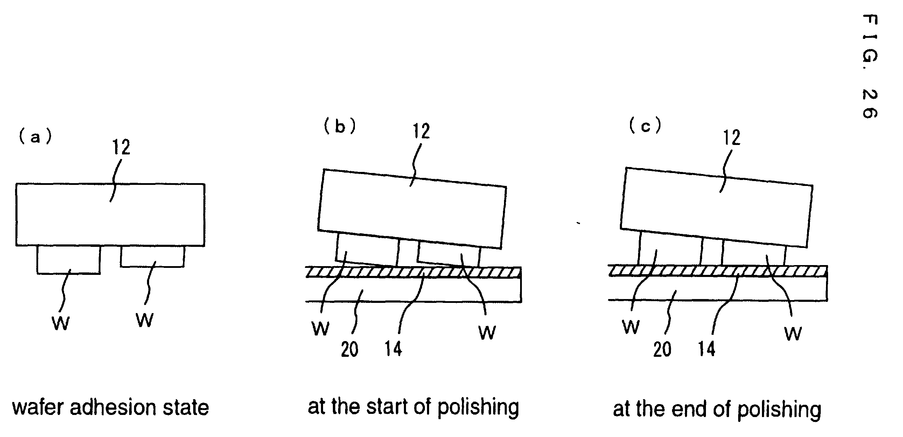

There exist variations in thickness (at a level of several µm) of wafers that are supplied to a polishing step. Hence, mixed wafers of different thicknesses are adhered on a wafer holding plate. When the wafers are polished in such a state, polishing conditions are varied among wafers as well as within a wafer surface as shown in FIG. 26, and thereby it is impossible to obtain flat wafers.

### External Disturbance ②:

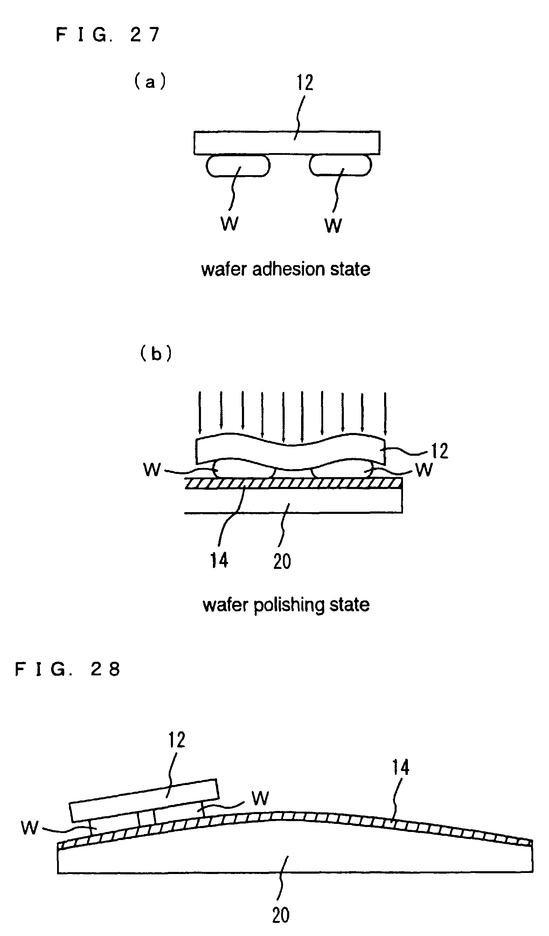

The wafer holding plate is of high stiffness and flatness thereof is desirably kept without elastic deformation even when a polishing load is imposed thereon. As a material of the plate, a high stiffness material such as Pyrex glass (borosilicate glass) or Al₂O₃ ceramic is selected. A thicker plate is preferred from the viewpoint of high stiffness, but the thicker plate is disadvantageously heavy to be handled or has a limitation of the obtainable thickness level so that the thickness of the plate is limited by itself. Therefore, stiffness of a wafer holding plate is insufficient as compared with an ideal state and the wafer holding plate is elastically deformed. FIG. 27 illustrates a concept of elastic deformation when a uniformly distributed load is imposed on the wafer holding plate. In such a situation, it is impossible to obtain a flat polished wafer.

### External Disturbance ③:

A wafer is polished while it is held between the wafer holding plate and the table on which the polishing cloth is stuck and therefore both of them are necessarily flat in order to obtain a flat wafer. However, in company with a recent progress toward a large diameter of a wafer, diameters of a wafer holding plate and a table have both increased, thereby flatness processing being more difficult. In FIG. 28, there is shown a case where flatness of a table is poor and in this case polishing conditions for a wafer surface are not uniform, thereby difficulty of flatness processing being increased.

How the external disturbances shown in the case of the batch type wafer polishing apparatus produce effects on the single wafer polishing apparatus will be explained below by a comparison between them.

### External Disturbance ①:

Even with variations in thickness between starting wafers, the single wafer polishing apparatus can polish wafers to a high flatness level since each of wafers is processed independently without mutual interference from other wafers.

### External Disturbance ②:

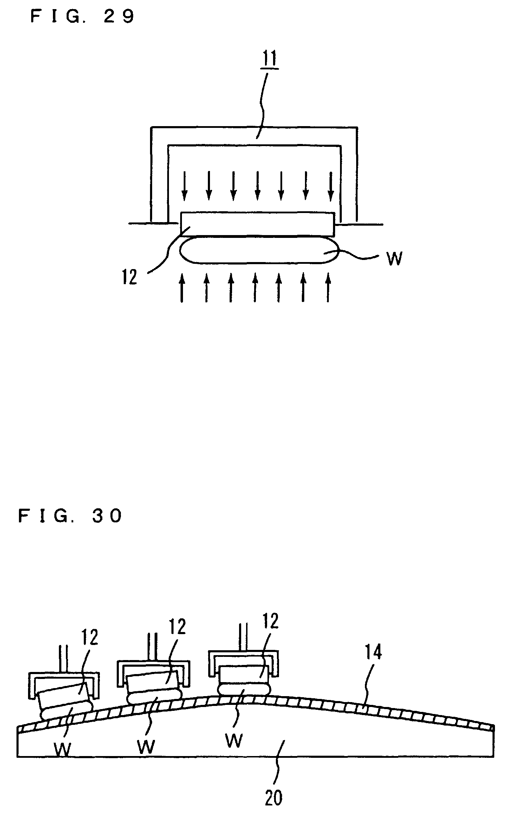

In a case of a polishing head of a single wafer polishing apparatus shown in FIG. 29, loads imposed on both surfaces of a wafer holding plate are uniformly distributed and locally offset each other, so that the wafer holding plate is not deformed elastically, thereby wafers being polished to a high flatness level.

### External Disturbance ③:

In the single wafer polishing apparatus, even when a table has poor flatness, as shown in FIG. 30, wafers are moved slantwise according to flatness of the table, thereby the wafers being polished to a high flatness level.

The present invention has been made in the light of the above described problems in the prior art and it is an object of the present invention to provide an apparatus and a method for polishing a wafer which solve the demerit of the single wafer polishing apparatus that production costs thereof are high and the demerit of the batch type polishing apparatus that flatness of a polished wafer obtained thereby is poor, and have the merit of the single wafer polishing apparatus that flatness of a polished wafer obtained thereby is excellent and the merit of the batch type wafer polishing apparatus that production costs thereof are low.

### Disclosure of the Invention

In order to solve the above described problems, a first aspect of a wafer polishing apparatus of the present invention is directed to a wafer polishing apparatus in which wafers held on a wafer holding plate are pressed onto a polishing cloth stuck on a table with a predetermined polishing load using a loading member and thereby one surface of each of the wafers is polished, wherein the wafer holding plate comprises: a plurality of wafer holding sections on which the wafers are held respectively; and a connection plate section that connects a plurality of the wafer holding sections in one united body, the wafer holding sections being formed as high stiffness regions while the connection plate section being formed as a low stiffness region, wherein the plural wafer holding sections are provided with uniform load distribution means for uniformly distributing the polishing load on the plural wafer holding sections respectively.

The wafer holding sections are greater in thickness and the connection plate section is smaller in thickness, thereby enabling the wafer holding sections and the connection plate section to be high stiffness regions and a low stiffness region respectively.

Through-holes are bored in the connection plate section, thereby enabling the connection plate section to be a low stiffness region.

A structure may also be adopted in which a plurality of the wafer holding sections are equal in thickness and all upper and under surfaces of a plurality of the wafer holding sections are on the same plane and both the upper and under surfaces are respectively projected outward more than upper and under surfaces of the connection plate section.

It is preferable that the wafer holding sections are made of a high stiffness material such as Al₂O₃ ceramics or SiC ceramics and the connection plate section is made of a low stiffness material of heat-resistant glass such as borosilicate glass (Pyrex glass), or synthetic resin such as epoxy resin or polytetrafluoroethylene resin (Teflon resin).

The uniform load distribution means works to uniformly distribute a load on another surface of the wafer holding plate opposite to one surface thereof in contact with wafers and a viscoelastic material that is interposed between the loading member and the wafer holding plate is employed as the uniform load distribution means.

As the viscoelastic material, there may be used a rubber sheet, a foam rubber sheet or the like made of natural rubber or synthetic rubber.

As the uniform load distribution means, an elastic material, such as a spring interposed between the loading member and the wafer holding plate may be employed.

As the uniform load distribution means, a fluid material such as water or air interposed between the loading member and the wafer holding plate may also be employed.

A second aspect of a wafer polishing apparatus of the present invention is directed to a wafer polishing apparatus in which wafers held on a plurality of wafer holding plates constituting a polishing head are pressed onto a polishing cloth stuck on a table with a predetermined polishing load using a loading member and thereby one surface of each of the wafers is polished, wherein the polishing head is constructed by arranging the plural wafer holding plates on a surface of a high stiffness structure movably upward, downward and slantwise.

As a first configuration in which the plural wafer holding plates are arranged on the surface of the high stiffness structure, there can be adopted a configuration in which the wafer holding plate is made of a high stiffness disk with a larger diameter than that of a wafer and arranged on the surface of the high stiffness structure with an elastic action member in between.

As a second configuration in which the plural wafer holding plates are arranged on the surface of the high stiffness structure, there can be adopted a configuration in which a convex spherical working surface made of a convex spherical surface with the center thereof being in a line with a center of a wafer surface to be polished is formed on an upper surface of the wafer holding plate, thereby the relative movement between the wafer holding plate and the high stiffness structure necessary for the slantwise motion of the wafer holding plate being absorbed.

It is preferable that, as a structure setting the wafer holding plate, a concave spherical receiving section is formed on the under surface of the high stiffness structure and the wafer holding plate is set on the under surface of the high stiffness structure in a state where the convex spherical working surface is mated with the concave spherical receiving section.

The convex spherical working surface and the concave spherical receiving section are mated with each other with an elastic action member in between, so upward, downward and slantwise motions are advantageously effected to the full.

A third aspect of a wafer polishing apparatus of the present invention is directed to a wafer polishing apparatus in which semiconductor wafers held on a plurality of wafer holding plates constituting a polishing head are pressed onto a polishing cloth stuck on a table with a predetermined polishing load using a loading member and thereby one surface of each of the semiconductor wafers is polished, wherein a collective wafer holding plate is constructed by arranging the plural wafer holding plates on a surface of a high stiffness circular plate movably upward, downward and slantwise and the polishing head is constructed by arranging the collective wafer holding plate on a surface of a high stiffness structure movably upward, downward and slantwise

As a configuration in which the plural wafer holding plates are arranged on the surface of a high stiffness circular plate, there can be adopted a configuration in which the wafer holding plate is made of a high stiffness disk with a larger diameter than that of a wafer and the wafer holding plates are arranged on the surface of a high stiffness circular plate with elastic action members in between. As a configuration in which the collective wafer holding plate is arranged on the surface of a high stiffness structure, there can be adopted a configuration in which the collective wafer holding plate is arranged on the surface of a high stiffness structure with an elastic action member in between.

A wafer polishing method of the present invention is a wafer polishing method in which a plurality of wafers held on a wafer holding plate or a plurality of wafer holding plates are pressed on a polishing cloth stuck on a table by a predetermined polishing load and thereby one surfaces of the plural wafers are polished, wherein using one of the above described wafer polishing apparatuses, the plural wafers are pressed with a load distributed uniformly thereon and each of the plural wafers is uniformly polished.

As an elastically acting member used in the present invention, there can be named an elastic material or a viscoelastic material. As an elastic material, there can be used, for example, a spring such as a leaf spring or a coil spring. As a viscoelastic material, there can be used, for example, a rubber sheet or a foam rubber sheet made of natural rubber or synthetic rubber, the rubbers being preferably used in the form of a thin film.

A main point of the present invention is in that basic advantageous technologies of the single wafer polishing apparatus and the batch type wafer polishing apparatus are integrated so as to provide an apparatus and a method for polishing a wafer that have the advantages of both apparatuses.

### Brief Description of the Drawings

FIG. 1 is a sectional side view illustrating an essential part of an embodiment of a wafer polishing apparatus of the present invention;
FIG. 2 is a schematic top view of FIG. 1;
FIG. 3 is a plan view showing an example of a wafer holding plate;
FIG. 4 is an enlarged, sectional view illustrating a main part of the wafer holding plate of FIG. 3;
FIG. 5 is a plan view showing another example of a wafer holding plate;
FIG. 6 is an enlarged, sectional view illustrating an essential part of the wafer holding plate of FIG. 5;
FIG. 7 is a schematically illustrative side view conceptually showing a buffer action of a wafer holding plate of the present invention for variations in wafer thickness;
FIG. 8 is a schematically illustrative side view conceptually showing a slave action of a wafer holding plate of the present invention for a table surface;
FIG. 9 shows illustrative side views for a relation between a force acting on a wafer holding section and flatness of a wafer, (a) shows a case where a load acts on the gravity center of the wafer holding plate and (b) shows a case where a load does not act on the gravity center of the wafer holding plate;
FIG. 10 shows illustrative sectional views for still other examples of a wafer holding plate, (a) shows a case where plate thicknesses of the wafer holding plate and a connection plate section are same as each other and (b) shows a case where a plate thickness of the connection plate section is thinner;
FIG. 11 shows illustrative sectional views for three examples of assembly when a viscoelastic material is employed as a uniform load distribution means, (a) is a first example, (b) is a second example and (c) is a third example;
FIG. 12 is an illustrative sectional view showing an example of assembly when an elastic material is employed as a uniform load distribution means;
FIG. 13 is an illustrative sectional view showing an example of assembly when a fluid material is employed as a uniform load distribution means;
FIG. 14 is an illustrative schematic side view showing another embodiment of a wafer polishing apparatus of the present invention;
FIG. 15 is an illustrative schematic side view showing still another embodiment of a wafer polishing apparatus of the present invention;
FIG. 16 shows representations for polishing pressure distributions caused by kinetic friction, (a) is an illustrative schematic side view showing a positional relation between a wafer holding plate and a polishing cloth when only a downward pressure is applied, (b) is a representation showing a polishing pressure distribution when only a downward pressure is applied, (c) is an illustrative schematic side view showing a positional relation between a wafer holding plate and a polishing cloth during polishing and (d) is a representation showing a polishing pressure distribution during polishing;
FIG. 17 is an illustration for a principle of force balance on a spherical bearing;
FIG. 18 is an illustrative schematic side view showing yet another embodiment of a wafer polishing apparatus of the present invention;
FIG. 19 is an illustrative side view showing a buffer action for variations in wafer thickness in a wafer polishing apparatus of the present invention;
FIG. 20 is an illustrative side view showing a slave action for a low flatness table in a wafer polishing apparatus of the present invention;
FIG. 21 is an illustrative schematic sectional side view showing an example of a conventional wafer polishing apparatus;
FIG. 22 is an illustrative schematic sectional side view showing an example of an essential part of a single wafer polishing apparatus;
FIG. 23 shows illustrations for relations in arrangement between a table and a wafer holding plate or wafer holding plates according to the number of shafts equipped in a single wafer polishing apparatus, (a) shows a case of one shaft, (b) shows a case of two shafts and (c) shows a case of six shafts;
FIG. 24 is an illustrative schematic sectional side view showing an example of an essential part of a batch type wafer polishing apparatus;
FIG. 25 is an illustration for a relation in arrangement of a table and wafer holding plates in a batch type wafer polishing apparatus;
FIG. 26 shows illustrative conceptual side views in a case where wafers of different thicknesses are simultaneously polished in a batch type wafer polishing apparatus, (a) shows a wafer adhesion state, (b) shows a state of the wafers at the start of polishing and (c) shows a state of wafers at the end of polishing;
FIG. 27 shows illustrative side views for a state of wafer flatness degraded by deformation of a wafer holding plate in a batch type wafer polishing apparatus, (a) shows a wafer adhesion state and (b) shows a wafer polishing state;
FIG. 28 is an illustrative side view showing a polishing state in case of a low flatness table in a batch type wafer polishing apparatus;
FIG. 29 is an illustration for an influence of elastic deformation of a wafer holding plate in a single wafer polishing apparatus; and
FIG. 30 is an illustrative side view showing a polishing state in a case of a low flatness table in a single wafer polishing apparatus.

### Best Mode of Carrying Out the Invention

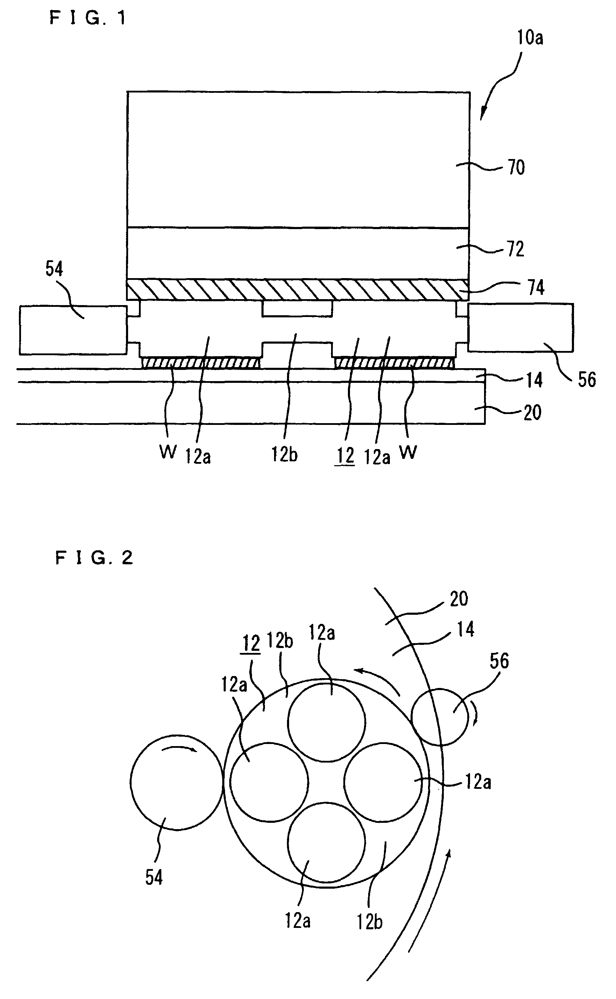

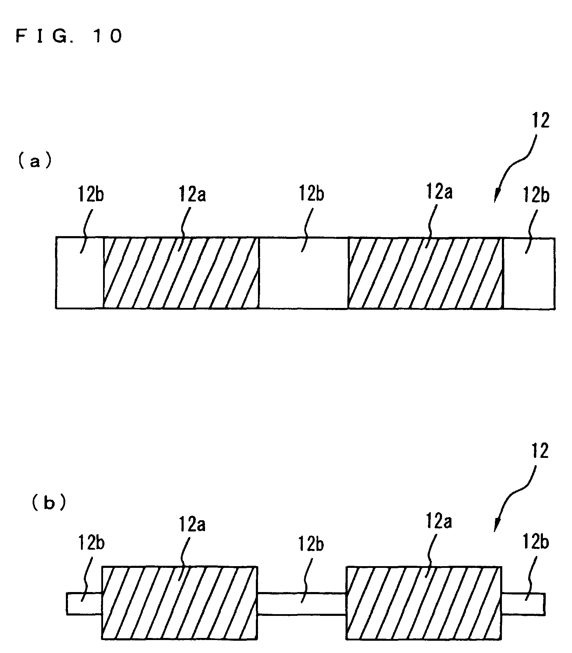

The present invention will hereinafter be described with reference to some embodiments illustrated in FIGs. 1 to 20 of the accompanying drawings and it is further understood that various changes and alterations of the examples shown in the figures may be made in the present invention without departing from the technical idea thereof. In FIGs. 1 to 20, members identical or similar to those in FIGs. 21 to 30 may be designated by the same reference characters.

In FIG. 1, reference character 10a indicates a wafer polishing apparatus of the present invention and a plurality of wafers (W) held on a wafer holding plate 12 are pressed onto a polishing cloth 14 stuck on a table 40 under a predetermined polishing load using a loading member 70 to simultaneously polish one surface of each of the plural wafers (W). While a dead weight is employed in the example shown in the figure as a loading member 70, a fluid pressure such as air or wafer can be applied as well. Reference character 72 indicates a load receiving section that receives the loading member 70. Reference character 74 is a uniform load distribution means that is interposed between the load receiving section 72 and the wafer holding plate 12.

The wafer holding plate 12 comprises a plurality of wafer holding sections 12a (4 sections in the example shown in the figure) on which wafers (W) are held respectively and a connection plate section 12b that connects the plural wafer holding sections 12a in one united body. The plural wafer holding sections 12a are formed as high stiffness regions while the connection plate section 12b is formed as a low stiffness region with flexibility.

In FIGs. 1 and 2, reference character 54 indicates a center roller and reference character 56 a guide roller. The wafer holding plate 12, as shown in FIG. 2, rotates on a table 20 by dint of the rollers 54 and 56. Accordingly, a wafer (W) held on the under surface of the wafer holding plate 12 is rubbed and polished while revolving and rotating on the polishing cloth 14.

A wafer holding section 12a of the wafer holding plate 12 which is in contact with a wafer (W) is hard to be deformed since the section 12a is a high stiffness region, while the connection plate section 12b is deformed with ease since the section 12b is a low stiffness region. Hence, almost all deformation in the wafer holding plate 12 may occur in the connection plate section 12b of a low stiffness region.

From a consideration of occurrence of a little positioning error when holding a wafer (W) on a wafer holding section 12a, a size of the wafer holding section 12a is selected to be slightly larger (about 5mm in diameter) than that of a wafer (W). Transmission of a load to the wafer holding plate 12 is limited to the wafer holding sections 12a of higher stiffness so as to reduce deformation of the wafer holding plate 12.

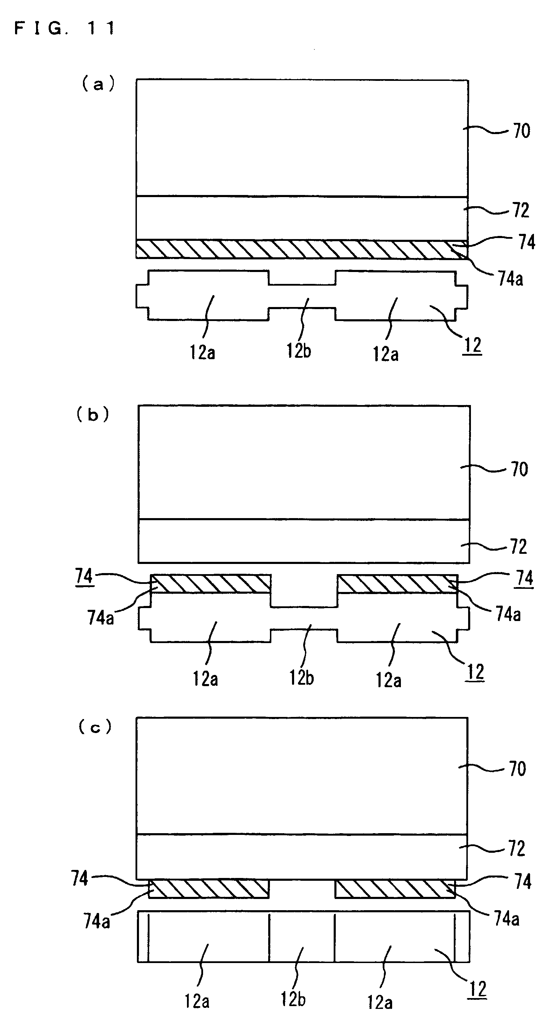

As a uniform load distribution means 74 that transmits the load 70 to the wafer holding plate 12, for example, a viscoelastic material 74a is employed as shown in FIG. 11. The viscoelastic material 74a is soft and a change in magnitude of a compressive stress may be slight even when there occurs a change in compressive deformation by about 10µm.

With the above described configuration, the following three advantages are obtainable in achievement of wafer flatness:

### Advantage ①:

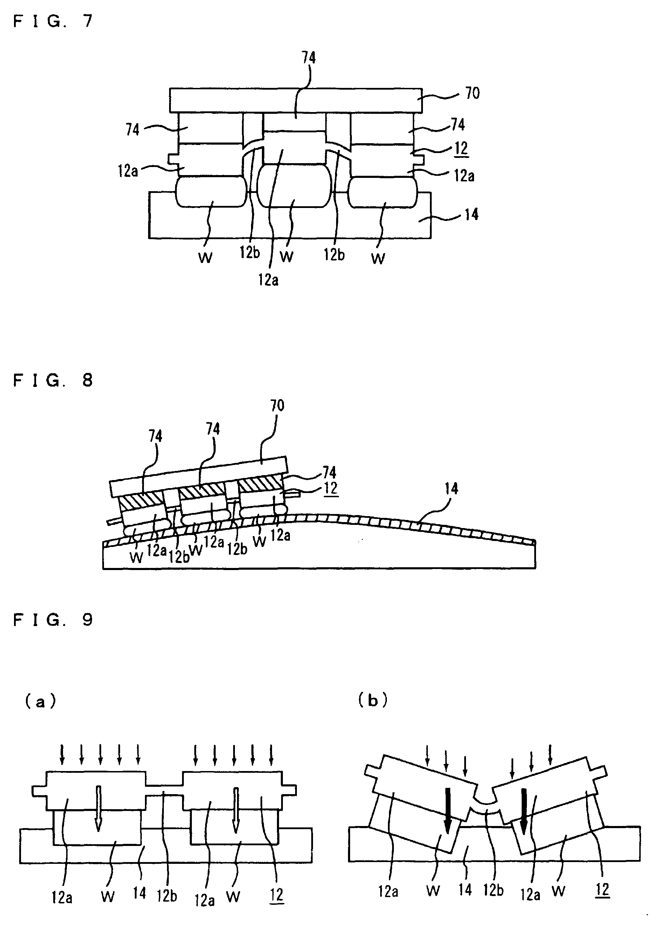

As shown in FIG. 7, even in a case where a wafer holding plate 12 holds wafers (W) which have different thicknesses respectively, deformation arises in a connection plate section 12b of a low stiffness region, while a wafer holding section 12a of a high stiffness region with which the wafers (W) are contact is not deformed and thereby flatness thereof is retained. Accordingly, the wafers (W) are polished to good flatness. Further, since changes in thickness among the wafers (W) are not more than 10µm, variations of compressive stress generated in the uniform load distribution means 74 of a viscoelastic material or the like are slight. Hence, variations of pressures with which the wafers W press the polishing cloth 14, that is, polishing pressures are also slight. Therefore, a difference in the way of being polished among the wafers (W) is slight, leading to no difference in quality among the wafers (W).

### Advantage ②:

Forces that act on a wafer holding section 12, which is a high stiffness region of the wafer holding plate 12, from the wafer (W) and the uniform load distribution means 74 made of the viscoelastic material or the like are opposed to each other in their directions, distributed almost uniformly and have working areas almost overlapped. In addition to the above matter, the wafer holding section 12a of a high stiffness region is higher in stiffness so as not to be deformed. Accordingly, the wafers (W) are polished to a high flatness level.

### Advantage ③:

Even when a surface of the table 20 is not of perfect flatness, since the wafer holding sections 12a of the high stiffness regions on which the wafers (W) are held respectively are higher in mobility, the wafers (W) follow unevenness on the surface of the table 20. Therefore, the wafers (W) with high flatness may be obtained.

As shown in the above three advantages, each wafer (W) can move independently from one another without any interference. The above movement of the wafer is the same manner as in a single wafer polishing apparatus, so that high flatness polishing can be realized.

Then, a per unit processing capacity of a wafer polishing apparatus of the present invention that exerts a great influence on production costs will be described on a case where the wafer polishing apparatus 10a of the present invention is employed.

Wafer holding sections 12a of high stiffness regions on which wafers are held are densely arranged on a wafer holding plate 12. Since a wafer (W) and the wafer holding sections 12a of high stiffness regions are almost equal in size, a packing density of wafers (W) on the wafer holding plate 12 may be almost equal to that of the wafers (W) on a wafer holding plate 12 of a batch type wafer polishing apparatus 60. Furthermore, a packing density of the wafer holding plates 12 on the table 20 can be equal to that of the batch type wafer polishing apparatus 60. That is, the number of wafers (W) that can be processed in one unit of the polishing apparatus is equal to that of the batch type wafer polishing apparatus 60.

Also, although the wafer polishing apparatus 10a of the present invention is different from the above described batch type wafer polishing apparatus 60 in regard to the wafer holding plate 12 and the pressure structure against the wafer holding plate 12, the other components are common to each other. Accordingly, the cost of the wafer polishing apparatus 10a of the present invention is almost equal to that of the batch wafer polishing apparatus.

Further, the wafer polishing apparatus 10a of the present invention and the batch type wafer polishing apparatus 60 are almost equal with respect to a machine size, that is a floor space for installment. Therefore, there is little difference in wafer production costs between the wafer polishing apparatus 10a of the present invention and the batch type wafer polishing apparatus. In this way, the wafer polishing apparatus 10a of the present invention can have both advantages of the single wafer polishing apparatus that is excellent in flatness and the batch type wafer polishing apparatus that is low in production costs.

Further, in an apparatus of the present invention, an equilibrium of forces acting on a wafer holding section 12a of a high stiffness region of a wafer holding plate 12 and flatness of a wafer, so the attention is to be paid at a similar level to the case of a single wafer polishing apparatus. That is, a resultant force obtained from forces acting on a wafer holding section 12a of a high stiffness region, from the uniform load, distribution means 74 made of a viscoelastic material or the like has to act so as to pass through the gravity center of a wafer surface, that is, in a case of a wafer with a perfect circularity, through the center of the wafer surface, or in a case of a wafer with an orientation flat, through a position shifted from the center of the wafer surface toward an opposite direction from the orientation flat.

In a case where the resultant force acts at the gravity center of the wafer, a polishing pressure occurring between the wafer (W) and the polishing cloth 14 is uniformly distributed within the surface of the wafer (W), leading to preferable achievement of flatness of the wafer (W) (FIG. 9(a)), but in a case where a resultant force does not act at the gravity center of the wafer, the polishing pressure is not uniform, leading to deterioration of flatness of the wafer (generation of a taper) (FIG. 9(b)).

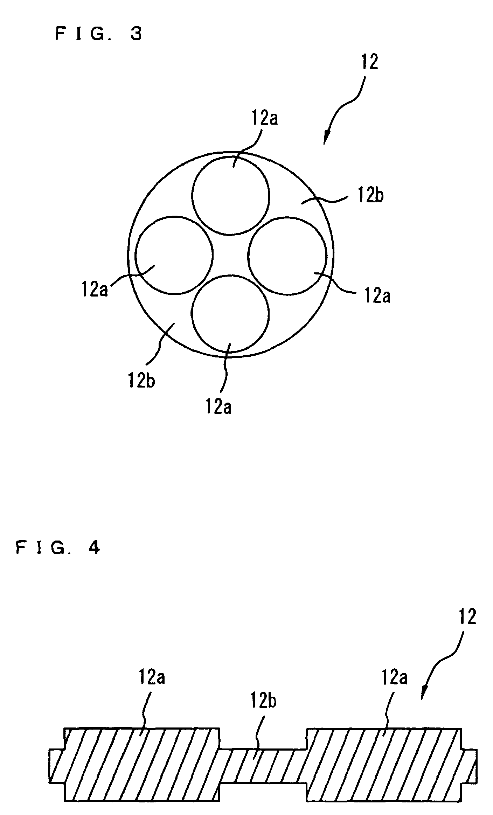

As a structure of the wafer holding plate 12, as shown in FIGs. 3 and 4, it is also acceptable that a high stiffness region is formed with an increased thickness of the wafer holding section 12a and a low stiffness region is formed with a decreased thickness of the connection plate section 12b.

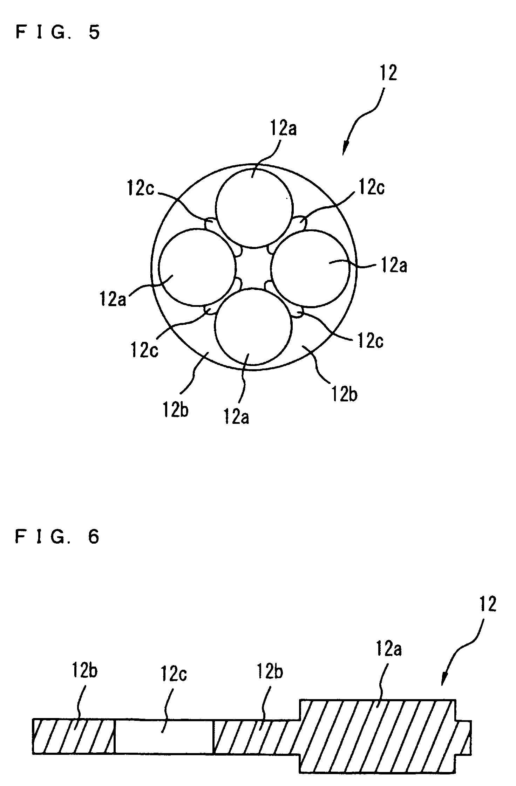

Also, as for the connection plate section 12b, with formation of through holes in the wafer holding section 12b, for example, as shown in FIGs. 5 and 6, boring holes 12c at positions in the vicinity of the wafer holding section 12b of high stiffness regions, stiffness of the connection plate section 12b can be reduced.

There is preferably provided a different structure from the above described wafer holding plate 12 wherein plate thicknesses of a plurality of wafer holding sections 12a of high stiffness regions are equal to each other, one surfaces of the plural plate holding sections 12a of high stiffness regions contacting with wafers (W) and another surfaces thereof are both in one plane and both of the surfaces are shifted outward from both surfaces of the connection plate section 12b of a low stiffness region (FIGs. 4 and 6).

The reason why the surfaces of the wafer holding sections 12a contacting with the wafers (W) are necessarily in the same plane is naturally because the surfaces contact with the table 20 with the wafers (W) in between. The reasons why the plate thicknesses of the wafer holding sections 12a are necessarily equal are because all the wafers (W) held on the wafer holding sections 12a are necessarily processed in the same conditions, and the wafer holding plate 12 is used in such a manner as sandwiched between the table 20 and the loading member 70 with a convenient result in manufacture of the wafer polishing apparatus.

In such a structure as the surface of the wafer holding plate 12 contacting with the wafers (W) is shifted outward from the connection plate section 12b, when cleaning the wafer holding plate 12 the surface contacting with the wafers (W) are easily cleaned. When the surface of the wafer holding plate 12 contacting with the uniform load distribution means 74 made of a viscoelastic material or the like is shifted outward from the connection plate section 12b of a low stiffness region, in the wafer polishing apparatus as shown in FIG. 1, an advantage is enjoyed that a small change in a positional relation between the uniform load distribution means 74 made of a viscoelastic material or the like and the wafer holding plate 12 does not induce any change in a load imposed on the wafer holding section 12a of high stiffness.

The wafer holding plates 12 can be made of various kinds of materials: for the wafer holding section 12a of a high stiffness region contacting with the wafer (W), a high stiffness material, for example, Al₂O₃ ceramics, SiC ceramics or the like; and for the connection plate section 12b of a low stiffness region, a low stiffness material, for example, heat-resistant glass such as Pyrex (borosilicate glass), epoxy resin, polytetrafluoroethylene resin (Teflon resin) or the like.

As the uniform load distribution means 74, a viscoelastic material 74a such as a rubber sheet, a foam rubber sheet or the like can be interposed between the loading member 70 and the wafer holding plates 12 (FIG. 11).

How the viscoelastic material 74a is interposed is configured in three ways as shown in FIG. 11. In FIG. 11(a), there is shown an example in which the viscoelastic material 74a is firmly attached onto the entire under surface of a load receiving section 72 and in this case, even when a relative positional displacement arises between the viscoelastic material 74a and the wafer holding plate 12, this displacement may be tolerant without any special problem.

In FIG. 11(b), there is shown an example in which the viscoelastic materials 74a are firmly attached on the upper surfaces of the wafer holding sections 12a, and in this case, when the wafer holding plate 12 is cleaned, the viscoelastic materials 74a are disadvantageously obstacles for cleaning.

In FIG. 11(c), there is shown an example in which the viscoelastic materials 74a are firmly attached onto areas only corresponding to the wafer holding sections 12a of the under surface of the load receiving section 72, and in this case, when a relative positional displacement arises between the viscoelastic material 74a and the wafer holding plate 12, a polishing pressure is not uniform within the wafer surface, which causes deterioration in wafer flatness, and hence precise positioning of the viscoelastic material 74a to the attaching portion is required.

Also, as the uniform load distribution means 74, an elastic material 74b, such as a spring may be interposed between the loading member 70 and the wafer holding plate 12.

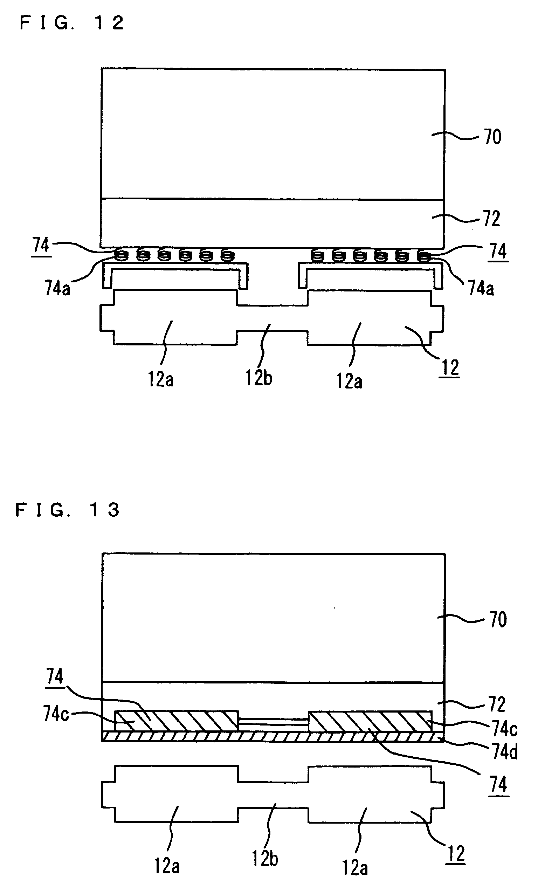

Further, as the uniform load distribution means 74, a fluid material 74c such as water or air may be interposed between the loading member 70 and the wafer holding plates 12 (FIG. 13). Since, especially, water is an incompressible fluid, it may be preferably used only by supplying and confining into a hermetically sealed space.

In FIG. 13, reference character 74d designates a viscoelastic sheet such as a rubber sheet provided on the under surface of the fluid material 74c, which is used to exert an auxiliary action in uniform distribution of a load.

Various modifications or alterations may be made in addition to the examples shown in the figures without departing from the technical idea of the present invention and, for example, techniques that have been employed in existing batch type wafer polishing apparatuses and single wafer polishing apparatuses may be selected in line with the object of the present invention.

In FIG. 1, while a technique using the guide rollers 56 and the center roller 54 is shown as a method in which each of the wafer holding plates 12 is retained, at a specific position in the polishing apparatus 10a; a table-drive technique is shown as a method for rotating the wafer holding plates 12; a dead weight technique is shown as a method for imposing a load; and a wax adhesion technique is shown as a wafer holding method, it is needless to say that various other techniques can be applied instead: a technique in which the wafer holding plate 12 and the load receiving section 72 are mechanically coupled with each other, a forced rotation technique, a pressing technique by means of an air cylinder, a vacuum suction technique in which a vacuum circuit reaching a wafer holding section is formed, and others.

In the above description, while polishing of a semiconductor wafer such as a silicon wafer is shown, the present invention may naturally be applicable for a thin plate other than a semiconductor wafer, for example, a quartz thin plate such as a quartz mask blank.

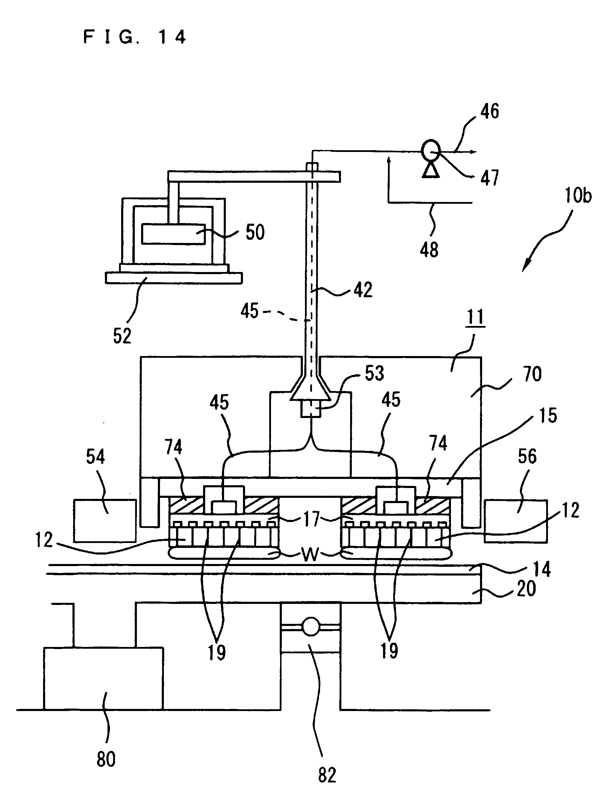

Next, there will be described another embodiment of a wafer polishing apparatus of the present invention shown in FIG. 14. In FIG. 14, reference character 10b designates a wafer polishing apparatus according to the present invention, in which above a polishing cloth 14 stuck on a table 20, a polishing head 11 is provided movably upward and downward in a manner opposing thereto with hanging from the lower end portion of a hanger means 42. The polishing head 11 has a high stiffness structure (a top ring in the figure) 15 and loading member 70 that exerts a polishing pressure on wafers (W) is placed on the top ring 15. While a dead weight is exemplified as the loading member 70 in the figure, as described above a liquid pressure such as air and water may also be applied instead.

The wafer holding plates 12 retaining the wafers W during polishing are arranged on the under surface of the top ring 15 with a backing plate 17 and an elastic action member 74 in between.

The top ring 15 receives a rotational force by rotation of the table 20 and is subjected to a rotational movement (the so-called a slave rotation) keeping in contact with the center roller 54 and the guide rollers 56. In this situation, a wafer (W) is polished through a frictional motion generated between the polishing cloth 14 and the wafer (W).

Each of the wafer holding plates 12 has many vacuum chuck holes 19 therein. Air pipes 45 penetrating through the hanger member 42 communicate with the vacuum chuck holes 19. When air is sucked through the air pipes 45 from a wafer vacuum chuck air line 46 using a vacuum pump 47, a wafer (W) is vacuum chucked on the under surface of the wafer holding plate 12. Also, when air is supplied through the air pipe 45 from a wafer separation air line 48, a wafer (W) that is vacuum chucked on the under surface of the wafer holding plate 12 is removed. In such a way, a wafer (W) is held detachably on the under surface of the wafer holding plate 12.

Reference character 50 designates an air cylinder provided on a frame 52 for moving the polishing head 11 upward and downward and carrying the same with the hanger member 42. Reference character 53 designates a rotary joint. Further, reference character 80 designates a table drive unit for driving the table 20 and reference character 82 a bearing.

In the wafer polishing apparatus 10b, in order to process a wafer (W) to be flat the wafer holding plate 12 is not deformed under any working conditions and the surface thereof is necessarily kept flat. Therefore, a material of the wafer holding plate 12 may preferably be high stiffness Al₂O₃ ceramics or the like. The larger the thickness of the wafer holding plate 12 is, the higher stiffness is preferably attained, but there is a given limitation on the thickness by the reason described below. In a case of the wafer holding plate 12 used for a 200mm diameter wafer, the thickness thereof may sufficiently be in the range of 10 to 30mm. The diameter of the wafer holding plate 12 larger than that of the wafer (W) by about 5mm may be easily used.

The elastic action member 74 allows the wafer holding plate 12 to move upward, downward, and slantwise. As the elastic action member 74, an elastic material or a viscoelastic material can be used. As the elastic material, a spring such as a leaf spring or a coil spring can be used. As the viscoelastic material, a rubber sheet or a foam rubber sheet made of natural rubber or synthetic rubber is preferably used, and there is preferable a small content of a viscosity component. It is preferable that the viscoelastic material is as soft as possible and has such a property as under a polishing pressure (about 200 to 1000g/m²) in usual wafer polishing, even if a change in compressive displacement thereof is about 10µm, a change in a compressive stress is 20g/m² or less.

The top ring 15 transmits a load of the dead weight 70 and a rotary motion thereof to the wafer holding plates 12 arranged on the surface thereof. Arrangement of the top ring 15 on the wafer holding plate 12 may preferably be such that a load is uniformly distributed on all the wafer holding plates 12, the adjacent wafer holding plates 12 are not interfered with each other, and the more the number of the arranged wafer holding plates 12, the better.

As stated above, holding of the wafers (W) on the wafer holding plate 12 is effected using a vacuum circuit connected to the vacuum pump 47 via the vacuum chuck holes 19 bored in the wafer holding plate 12, the back plate 17, the air pipe 45 and the rotary joint 53, and vacuum chucking of the wafer (W) is effected by moving the whole of the polishing head 11 upward, and conveying the wafers W to the wafer holding plate 12.

Quality advantages obtained by the present method are as follows:

### Advantage ①:

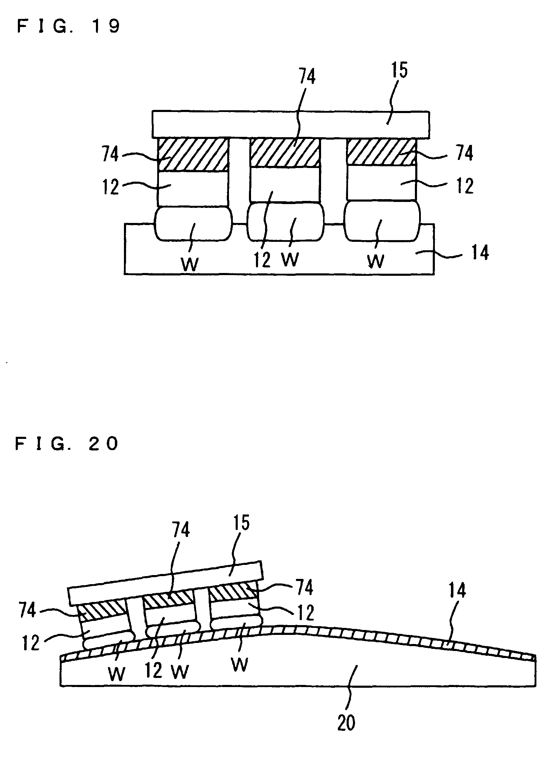

There are thickness variations of starting wafers to be polished, which are at the very most 10µm or less. Such thickness variations cause inconvenience in the batch type polishing apparatus 60 as described above. However, in the wafer polishing apparatus 10b of the present invention, as shown in FIG. 19, each of the wafer holding plates 12 is independent from each other and hence flatness of each wafer holding plate 12 is maintained with the result that there is no flatness deterioration of each wafer (W). Thickness variations of wafers (W) cause variations of compressive deformation of the elastic action member 74 but since the elastic action member 74 is sufficiently soft, variations of compressive stress thereof is small. That is, there is small variations of a polishing pressure generated by contact between the polishing cloth 14 and the wafers (W), so the wafers (W) are all polished in almost the same manner.

### Advantage ②:

Forces that the wafer polishing plate 12 is received from a wafer (W) and the elastic action member 74 are in opposed directions, almost uniformly distributed and nearly equal in the working areas. Hence, there is no deformation of the wafer holding plate 12. Accordingly, no influence is exerted on flatness of the wafer (W).

### Advantage ③:

As shown in FIG. 20, even when the surface of the table 20 is not flat, the wafer holding plates 12 follow unevenness on the surface of the table 20 and move upward, downward and slantwise. Accordingly, no influence is exerted on flatness of the wafer (W).

As shown in the above three advantages, in the wafer polishing apparatus of the present invention, each of the wafers (W) is independent without any interference with each other. Such functionality of the apparatus is the same as that of the single wafer polishing apparatus, so that high flatness polishing can be realized.

Then, a per unit processing capacity of a wafer polishing apparatus that exerts a great influence on production costs will be described on a case where the wafer polishing apparatus 10b of the present invention is employed.

The wafer holding sections 12a of the high stiffness regions are densely arranged on the wafer holding plate 12. Since the wafer (W) and the wafer holding section 12a of the high stiffness region are almost equal in size, a packing density of the wafer holding sections arranged on the wafer holding plate may be almost equal to that of the wafers (W) arranged on the wafer holding plate 12 of the batch type wafer polishing apparatus 60. Furthermore, a packing density of the wafer holding plates 12 on the table 20 may be equal to that of the batch type wafer polishing apparatus 60. That is, the number of the wafers (W) that may be processed per one unit is equal in both the polishing apparatus 10b and the batch type wafer polishing apparatus 60.

Also, although the wafer polishing apparatus 10b of the present invention is different from the above described batch type wafer polishing apparatus 60 in regard to the wafer holding plates 12 and the pressure structure thereto, the other components are common to them. Accordingly, the cost of the wafer polishing apparatus 10b of the present invention is almost equal to that of the batch wafer polishing apparatus.

Further, the wafer polishing apparatus 10b of the present invention and the batch type wafer polishing apparatus 60 are almost equal with respect to a machine size, that is a floor space for installment. Therefore, there is little difference in wafer production costs between the wafer polishing apparatus 10b of the present invention and the batch type wafer polishing apparatus. In this way, the wafer polishing apparatus 10b of the present invention can have both advantages of the single wafer polishing apparatus 10b that is excellent in flatness and the batch type wafer polishing apparatus 60 that is low in production costs.

As described above, the wafer polishing apparatus of the present invention can achieve the two advantages of flatness in the single wafer polishing apparatus and a low cost in the batch type wafer polishing apparatus.

Further, it should be noted that only specific techniques are described above for convenience of description, but the techniques described below are also naturally applied to the present invention.

There are employed for conveyance a method conveying wafers (W) adhered to the wafer holding plate 12 with wax, for rotation of the top ring 15 a forcibly rotating method and for application of a polishing load a pressing method by an air cylinder or the like.

Also, in the wafer polishing apparatus of the present invention, the wafer (W) is polished in the same manner as in the single wafer polishing apparatus and therefore the attention given in the single wafer polishing is required as much. Especially, a resultant force from composition of forces generated by compression of the elastic action member 74 acts necessarily on the gravity center of a wafer (W). Otherwise, the wafer (W) is polished in a tapered state.

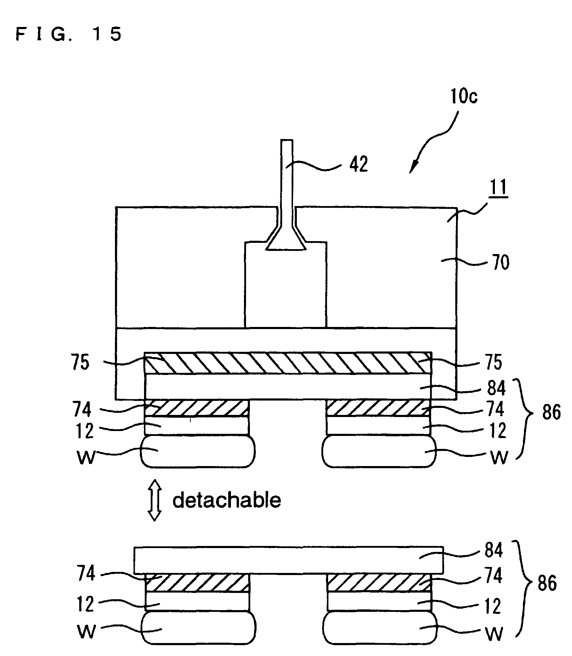

Next, there will be described still another embodiment of a wafer polishing apparatus of the present invention shown in FIG. 15. In a wafer polishing apparatus 10c of the present invention of FIG. 15, wafers (W) held on wafer holding plates 12 constituting a polishing head 11 are each polished on one surface thereof by being pressed on a polishing cloth 14 stuck on a table 20 with a predetermined polishing load using a loading member 70. While a dead weight is used as the loading member 70 in the figure, a fluid pressure such as air or water may be applied instead as described above.

In the wafer polishing apparatus 10c, the plural wafer holding plates 12 are arranged on a surface of a high stiffness circular plate 84 with an elastic action member 74 in between to form a collective wafer holding plate 86.

The collective wafer holding plate 86 is further detachably arranged on a surface of a high stiffness structure (top ring) 15 with an elastic action member 75 in between to form a polishing head 11. The collective wafer polishing plate 86 is detachable, so conveyance, cleaning and others can advantageously be conducted with ease.

In such a configuration, the wafers (W) are adhered and held on the surfaces of the wafer holding plates 12 with wax. Further, a function of the high stiffness circular plate 84 is to couple the plural wafer holding plates together without being broken up. In a case where the elastic action member 75 and the wafer holding plate 12 are equal in size and are located at the same position, there is no requirement for stiffness of the high stiffness circular plate 84. However, in order to facilitate positioning of the collective wafer holding plate 86 and the top ring 15, when the elastic action member 75 and the high stiffness circular plate 84 are equal in size, the high stiffness circular plate 84 is preferably of a higher stiffness.

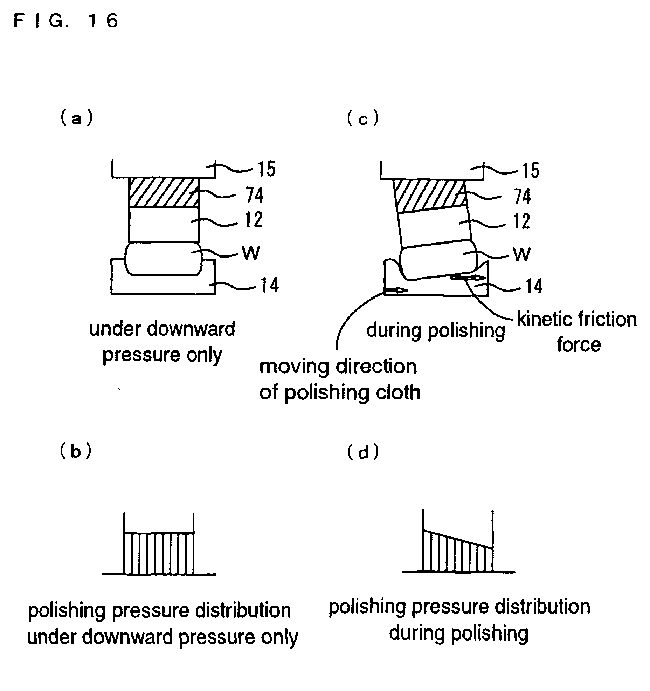

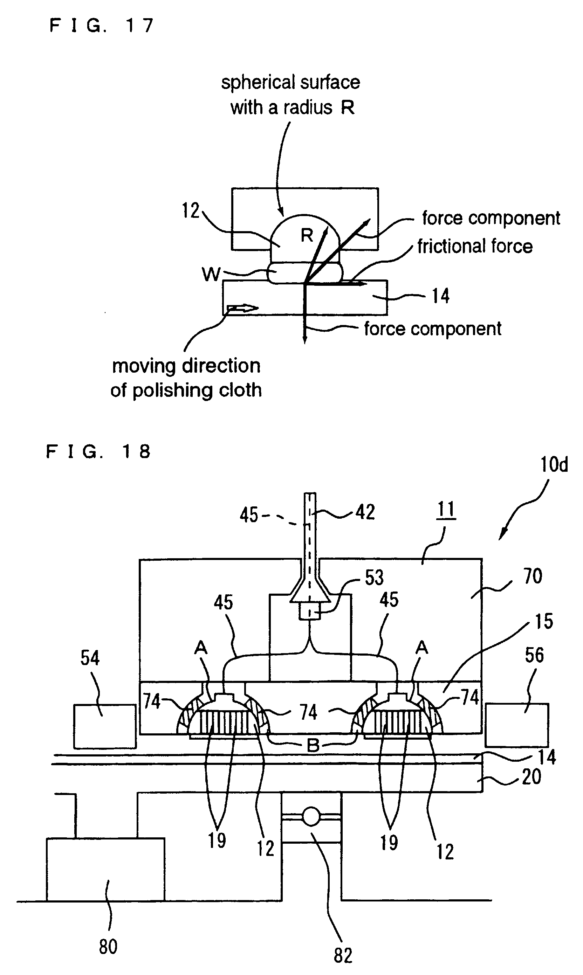

Subsequently, yet another embodiment of a wafer polishing apparatus of the present invention shown FIG. 18 will be described by reference to FIGs. 16 and 17. As shown extremely in FIG. 16, with a frictional force acting between the wafer (W) and the polishing cloth 14 during polishing, the wafer holding plate 12 cannot be retained in parallel to the polishing cloth 14, resulting in being slanted. In this situation, there arises a secondary effect that a polishing pressure acting on the wafer (W) becomes nonuniform. The extent of nonuniformity of the polishing pressure is proportional to a thickness of the wafer (W) and a coefficient of kinetic friction between the wafer (W) and the polishing cloth 14 but inversely proportional to a diameter of the wafer (W).

This is the reason why a thickness of the wafer holding plate 12 cannot be increased without restriction. When placing restrictions on a thickness of the wafer holding plate 12, not only the extent of nonuniformity can be suppressed to be small but a rubbing direction of the polishing cloth acting on a wafer surface by rotation of the top ring 15 is inverted, and hence the extent of nonuniformity of the polishing pressure is inverted so as to offset each other with the result that there is not so much influence on flatness of the wafer (W).

However, it is preferable that no nonuniformity is present. According to the wafer polishing apparatus 10d of the present invention shown in FIG. 18, the nonuniformity can be eliminated dynamically.

As shown in an illustration for a principle of force balance on a spherical bearing of FIG. 17, when a spherical surface whose center is accord with the center of a wafer surface to be polished is used as a working surface and a working resistance on the working surface is zero, it is proved that the surface of the wafer holding plate 12 and the polishing cloth 14 are kept in parallel even if a frictional force is present therebetween, leading to a uniform distribution of a polishing pressure on the wafer surface.

With the application of the above noted principle, the wafer polishing apparatus 10d that comprises a collective type polishing head shown in FIG. 18 has been invented.

In FIG. 18, reference character 10d indicates a wafer polishing apparatus according to the present invention, in which above a polishing cloth 14 stuck on a table 20 a polishing head 11 is provided movably upward and downward in a manner opposing thereto with hanging from the lower end portion of a hanger member 42. The polishing head 11 has a high stiffness structure (a top ring in the figure) 15 and loading member 70 that exerts a polishing pressure on wafers (W) is placed on the top ring 15. While a dead weight is exemplified as the loading member 70 in the figure, a liquid pressure such as air or water can also be applied instead.

A convex spherical working surface (A) made of a convex spherical surface whose center is in a line with the center of a wafer (W) surface to be polished is formed on the upper surface of the wafer holding plate 12 so as to absorb relative movement between the wafer holding plate 12 and the high stiffness structure (top ring) 15 required for slantwise motion of the wafer holding plate 12.

A concave spherical receiving section (B) is formed at the under surface of the high stiffness structure (top ring) 15. The convex spherical working surface (A) and a concave spherical receiving section (B) are mated with each other with the elastic action member 74 in between. The elastic action member 74 can easily absorb an upward and downward movement of the wafer holding plate 12. A slantwise movement of the wafer holding plate 12 becomes a movement in a tangential direction of the concave and convex spherical surfaces on a spherical surface, but the movement length is extremely small. Therefore, a displacement of the elastic action member 74 interposed between the concave and convex spherical surfaces is also small with the result that a working resistance between the spherical surfaces stands at zero.

In the above description, while polishing of a semiconductor wafer such as a silicon wafer is taken up, it is needless to say that the present invention can also be applied for thin plates other than a semiconductor wafer, for example a quartz thin plate such as a quartz mask blank.

### Capability of the Exploitation in Industry

As described above, according to the wafer polishing apparatus of the present invention, it is possible to polish wafers at low production costs and a high flatness level. According to the wafer polishing method of the present invention, wafers can be polished under a polishing pressure uniformly distributed, thus making it possible to obtain a high flatness wafer.

## Claims

1. A wafer polishing apparatus in which wafers held on a wafer holding plate are pressed onto a polishing cloth stuck on a table with a predetermined polishing load using a loading member and thereby one surface of each of the wafers is polished, wherein the wafer holding plate comprises: a plurality of wafer holding sections on which the wafers are held respectively; and a connection plate section that connects a plurality of the wafer holding sections in one united body, the wafer holding sections being formed as high stiffness regions while the connection plate section being formed as a low stiffness region, wherein the plural wafer holding sections are provided with uniform load distribution means for uniformly distributing the polishing load on the plural wafer holding sections respectively.

2. A wafer polishing apparatus according to claim 1, wherein the wafer holding sections are greater in thickness and the connection plate section is smaller in thickness, thereby enabling the wafer holding sections to be high stiffness regions and the connection plate section to be a low stiffness region.

3. A wafer polishing apparatus according to claim 1 or 2, wherein through-holes are bored in the connection plate section, thereby enabling the connection plate section to be a low stiffness region.

4. A wafer polishing apparatus according to any of claims 1 to 3, wherein a plurality of the wafer holding sections are equal in thickness and all upper and under surfaces of the plural wafer holding sections are on the same plane and both the upper and under surfaces are respectively projected outward more than upper an under surfaces of the connection plate section.

5. A wafer polishing apparatus according to claim 1, wherein a plurality of the wafer holding sections are made of a high stiffness material and the connection plate section is made of a low stiffness material

6. A wafer polishing apparatus according to claim 5, wherein the high stiffness material is Al₂O₃ ceramics or SiC ceramics and the low stiffness material is heat-resistant glass or synthetic resin.

7. A wafer polishing apparatus according to claim 6, wherein the heat-resistant glass is borosilicate glass and the synthetic resin is epoxy resin or polytetrafluoroethylene resin.

8. A wafer polishing apparatus according to any of claims 1 to 7, wherein the uniform load distribution means is a viscoelastic material that is interposed between the loading member and the wafer holding plate.

9. A wafer polishing apparatus according to claim 8, wherein the viscoelastic material is a rubber sheet or a foam rubber sheet made of natural rubber or synthetic rubber.

10. A wafer polishing apparatus according to any of claims 1 to 7, wherein the uniform load distribution means is an elastic material interposed between the loading member and the wafer holding plate.

11. A wafer polishing apparatus according to claim 10, wherein the elastic material is a spring.

12. A wafer polishing apparatus according to any of claims 1 to 7, wherein the uniform load distribution means is a fluid material interposed between the loading member and the wafer holding plate.

13. A wafer polishing apparatus according to claim 12, wherein the fluid material is water or air.

14. A wafer polishing apparatus in which wafers held on a plurality of wafer holding plates constituting a polishing head are pressed onto a polishing cloth stuck on a table with a predetermined polishing load using a loading member and thereby one surface of each of the wafers is polished, wherein the polishing head is constructed by arranging the plural wafer holding plates on a surface of a high stiffness structure movably upward, downward and slantwise.

15. A wafer polishing apparatus according to claim 14, wherein the wafer holding plate is made of a high stiffness disk with a larger diameter than that of a wafer and arranged on the surface of the high stiffness structure with an elastic action member in between.

16. A wafer polishing apparatus according to claim 14 or 15, a convex spherical working surface made of a convex spherical surface with the center thereof being in a line with a center of a wafer surface to be polished is formed on an upper surface of the wafer holding plate, thereby the relative movement between the wafer holding plate and the high stiffness structure necessary for the slantwise motion of the wafer holding plate being absorbed.

17. A wafer polishing apparatus according to claim 16, wherein a concave spherical receiving section is formed on the under surface of the high stiffness structure and the wafer holding plate is set on the under surface of the high stiffness structure in a state where the convex spherical working surface is mated with the concave spherical receiving section.

18. A wafer polishing apparatus according to claim 17, wherein the convex spherical working surface and the concave spherical receiving section are mated with each other with an elastic action member in between.

19. A wafer polishing apparatus in which semiconductor wafers held on a plurality of wafer holding plates constituting a polishing head are pressed onto a polishing cloth stuck on a table with a predetermined polishing load using a loading member and thereby one surface of each of the semiconductor wafers is polished, wherein a collective wafer holding plate is constructed by arranging the plural wafer holding plates on a surface of a high stiffness circular plate movably upward, downward and slantwise and the polishing head is constructed by arranging the collective wafer holding plate on a surface of a high stiffness structure movably upward, downward and slantwise.

20. A wafer polishing apparatus according to claim 19, wherein the wafer holding plate is made of a high stiffness disk with a larger diameter than that of a wafer and the wafer holding plates are arranged on the surface of a high stiffness circular plate with elastic action members in between and the collective wafer holding plate is detachably arranged on the surface of a high stiffness structure with an elastic action member in between.

21. A wafer polishing apparatus according to any of claims 14 to 20, wherein the elastic action member is made of an elastic material or a viscoelastic material.

22. A wafer polishing method in which a plurality of wafers held on a wafer holding plate or a plurality of wafer holding plates are pressed on a polishing cloth stuck on a table by a predetermined polishing load and thereby one surfaces of the plural wafers are polished, wherein using a wafer polishing apparatus according to any of claims 1 to 21, the plural wafers are pressed with a load distributed uniformly thereon and each of the plural wafers is uniformly polished.
